# EUROPEAN PATENT SPECIFICATION

(11) **EP 1 070 161 B1**
(45) Date of publication and mention of the grant of the patent: **02.01.2008**
(21) Application number: 99921328.3
(22) Date of filing: 31.03.1999
(51) Int. Cl.: C30B 25/08, C30B 25/12, C30B 25/14, C30B 29/36, C30B 35/00

(54) **A METHOD AND A DEVICE FOR EPITAXIAL GROWTH OF OBJECTS BY CHEMICAL VAPOUR DEPOSITION**
VERFAHREN UND VORRICHTUNG ZUM EPITAKTISCHEN WACHSTUM VON OBJEKTEN MITTELS CHEMISCHER DAMPFPHASENABSCHEIDUNG
PROCEDE ET DISPOSITIF DE CROISSANCE EPITAXIALE D'OBJETS PAR DEPOT CHIMIQUE EN PHASE VAPEUR

(30) Priority: 06.04.1998 SE 9801190
(43) Date of publication of application: 24.01.2001
(73) Proprietor: CREE, INC., Durham, NC 27703 (US)
(72) Inventor: LÖFGREN, Peter, S-723 53 Väster s (SE); HALLIN, Christer, S-583 31 Linköping (SE); GU, Chun, Yuan, S-722 46 Väster s (SE); LIU, Yujing, S-723 46 Väster s (SE)
(74) Representative: Olsson, Jan
(86) International application number: PCT/SE1999/000532
(87) International publication number: WO 1999/051797

(56) References cited:
- EP-A1- 0 068 839
- EP-A2- 0 147 967
- JP-A- 1 320 292
- PATENT ABSTRACTS OF JAPAN, Vol. 11, No. 43, (C-402); & JP 61205695 A (SUMITOMO ELECTRIC IND LTD) 11 Sept. 1986.
- J. ELECTROCHEM. SOC., Volume 143, No. 9, Sept. 1996, N. NORDELL et al., "Design and Performance of a New Reactor for Vapor Phase Epitaxy of 3C, 6H and 4H SiC", pages 2910-2919.

## Description

### TECHNICAL FIELD OF THE INVENTION AND PRIOR ART

The present invention relates to a device for epitaxial growth of objects by Chemical Vapour Deposition on a substrate according to the preamble of the appended independent device claim, as well as a method according to the preamble of the appended independent method claim.

The objects may be of any material, but the invention is primarily, but not exclusively, directed to the growth of crystals of semiconductor materials, such as in particular SiC and group III-nitrides or alloys thereof, since one of the main problems in such devices for Chemical Vapour Deposition (CVD) is to obtain such a high growth rate that the objects grown are interesting from the commercial point of view, and this problem is especially accentuated for the materials mentioned, which requires a very high temperature for being grown, and it has been necessary to raise the temperature even more to obtain higher growth rates.

As a consequence of this, and because SiC is a very interesting material for use in semiconductor devices, the growth of crystals of SiC will hereinafter primarily be discussed for illuminating, but not in any way restricting the invention. It is of course also of crucial importance that the objects grown has a high crystalline quality, but this invention is primarily directed to obtaining reasonable growth rates from the commercial point of view, but of course without compromising with the crystalline quality.

SiC single crystals are in particular grown for being used in different types of semiconductor devices, such as for example different types of diodes, transistors and thyristors, which are intended for applications in which it is possible to benefit from the superior properties of SiC in comparison with especially Si, namely the capability of SiC to work well under extreme conditions. For instance, the large band gap between the valence band and the conduction band of SiC makes devices fabricated from said material able to operate at high temperatures, namely up to 1 000 K.

As indicated above, it has been tried to raise the temperatures to which said susceptor and by that the gas mixture fed to the substrate and the substrate are heated above 2 000°C for obtaining reasonably high growth rates. This has also partially been successful, but those very high temperatures are of course associated with several problems, of which the temperature resistance of the material of different parts of the device and introduction of impurities are some.

Other ways to increase the growth rate without any reduction in quality are therefore very interesting, especially if they could be combined with other measures increasing the growth rate, such as the use of high temperatures for obtaining a still higher growth rate. Accordingly, a device and a method enabling this would have a large business impact.

### SUMMARY OF THE INVENTION

The object of the present invention is to provide a method and a device according to the introduction, which makes it possible to increase the growth rate when growing objects by CVD without a reduction in quality.

This object is obtained by providing such a device in which said means for holding the substrate is adapted to hold the substrate at a distance from internal walls of the susceptor and a method in which the substrate is held in the path of said gas mixture through the susceptor at a distance from internal walls thereof, so that there is a space between the back side of the means for holding the substrate and said internal walls.

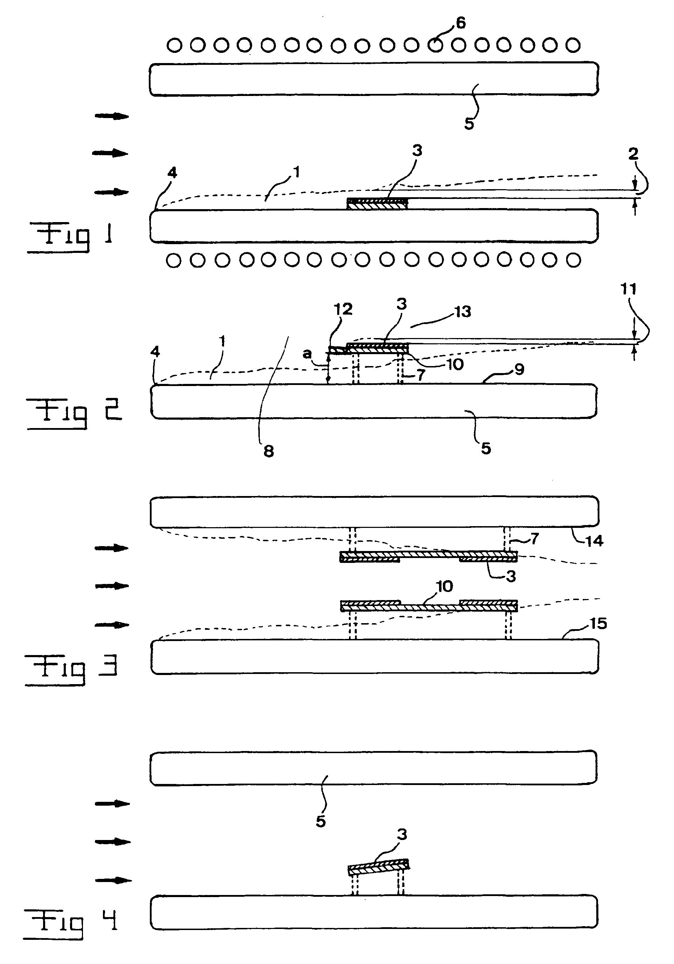

Accordingly, the inventors have realised that one important parameter upon which the growth rate is dependent is the thickness of a boundary layer at the substrate, and this boundary layer is a layer of the flow of said gas mixture in which the velocity thereof is lower than in the central part of the susceptor. The leading edge of the susceptor at the upstream end thereof creates such a boundary layer, and it is shown for a prior art device in fig. 1 how this boundary layer 1 looks like. The diffusion of species from the free stream above the boundary layer is important for the growth. This diffusion generally depends on the squared diffusive length 2. On the other, it is not possible to arrange the substrate 3 directly at the leading edge 4 of the susceptor 5, since the gas mixture has to be heated to a desired temperature before reaching the substrate, and this gas mixture is heated by radiative heating from the susceptor walls being heated by a heating means 6 surrounding the susceptor, here an Rf-field generating coil. Accordingly, the substrate has to be placed at a substantially distance downstream said leading edge 4, which in the prior art devices results in a considerable diffusive length 2.

Accordingly, the invention is based on moving the substrate away from the internal walls of the susceptor, through which the influence of the boundary layer 1 created by the leading edge 4 of the susceptor may be reduced or totally eliminated if said distance is large enough. This means that the diffusive length of species from said free stream of the gas mixture to the surface of the substrate is substantially reduced and by that a large increase in the growth rate is obtained.

According to a preferred embodiment of the invention said means is arranged to hold the substrate separated from said internal walls of the susceptor by at least a distance corresponding to the thickness of a boundary layer with a lower velocity of the gas mixture and created by a leading edge of the susceptor at the upstream end thereof with respect to the flow of the gas mixture through the susceptor. It is preferred to hold the substrate that much separated from the internal walls of the susceptor, since the boundary layer created by said leading edge of the susceptor will then not at all produce any diffusive length from said free stream of the gas mixture to the substrate, but any boundary layer next to the substrate will then only depend on the distance between the leading edge of said holding means and the substrate, and this distance can be made as short as wanted.

According to another preferred embodiment of the invention said means extends from a rear part of the susceptor with respect to the flow direction of said gas mixture through the susceptor in the direction opposite to said flow while being separated from and without contact with said internal walls of the susceptor along the extension thereof from said rear part. This means that there will not be any problem of any transport of material from surfaces of the internal walls of the susceptor as a consequence of a temperature gradient between the susceptor walls and a holding means in contact therewith. In the case that the internal walls of the susceptor are coated by a protective material, such as SiC, this would otherwise be transported to the holding means, so that the susceptor material thereunder, normally graphite, will be bared and in that case increase the total pressure of hydrocarbons in the susceptor. Accordingly, the susceptor lifetime would be reduced and impurities coming from the susceptor will be an additional uncontrolled growth parameter. However, these problems are solved by this preferred embodiment of the invention.

According to another preferred embodiment of the invention said holding means is secured outside a room of the susceptor defined by said internal walls and in which said growth is intended to take place and extends into said room without any contact to said walls therein, said holding means comprises a member secured to the susceptor outside said room and this member has a fork like design with two forks secured to opposite walls of the susceptor while being separated by them from said room. This constitutes a preferred way to realise an embodiment solving the problems of material transport from the internal walls just described.

According to another preferred embodiment of the invention said holding means comprises a plate, on which at least two substrates are arranged in series along said gas mixture flow path at said distance to internal walls of the susceptor. Such an arrangement in series in the direction of the gas mixture flow will of course also increase the growth rate in the sense that more objects may be grown at the same time, and this is made possible thanks to the fact that said plate is held at a distance from the internal walls of the susceptor, so that the plate and by that the substrate is not in contact with the walls any longer and will only be heated therethrough by radiative heating and the temperature gradient in the flow direction inside the susceptor will by that be remarkably decreased. This means that a substantially uniform temperature will be obtained over a considerable distance in said flow direction in the susceptor, so that two objects grown in this way in series will have substantially the same growth conditions and by that substantially the same quality.

According to another preferred embodiment of the invention the susceptor is adapted to be arranged with said path extending substantially horizontally therethrough, and the device comprises two holding means, one connected to a ceiling of the susceptor for holding a substrate at said distance therefrom and another connected to the bottom of the susceptor for holding another substrate at said distance therefrom. This means that the production capacity of the device will be doubled with respect to only arranging one substrate at the bottom of the susceptor as in devices previously known, so that it may be said that the growth rate is increased.

According to another preferred embodiment of the invention said means is arranged to hold the substrate inclined with respect to the path of the flow of said gas mixture through the susceptor, so that a perpendicular to the surface of the substrate has a component in the direction opposite to the direction of said flow. It has turned out that such an inclination of the substrate results in optimal growth conditions and also increases the growth rate.

According to another preferred embodiment of the invention the susceptor is at a downstream end thereof prolonged by an outlet substantially beyond the end of the heating means. This means that the temperature gradient in the flowing direction in the susceptor will be decreased, so that several substrates may be arranged in series in that direction while still obtaining a uniform growth. This also, in the case of inductive heating, results in a displacement of the end effect and its eddy current flow to the rear part of the outlet instead of the rear part of the susceptor, which is favourable for the temperature distribution inside the susceptor.

According to another preferred embodiment of the invention at least one heat shield is arranged downstream of an outlet of the susceptor for said flow of gases for reflecting thermal energy back towards the susceptor. Also this inventional feature reduces the temperature gradient inside the susceptor, and more exactly the temperature is nearly not falling at all from the mid region of the susceptor to said outlet, so that it will be possible to arrange a number of substrates in series inside the susceptor and grow objects thereon under substantially the same conditions.

According to another preferred embodiment of the invention the device has an inlet connected to the upstream end of the susceptor and formed by converging walls guiding said gas mixture into the susceptor, which will improve the flow pattern of the gas mixture in the susceptor.

The advantages of the different embodiments of the method according to the invention appear from the discussion above of the different embodiments of the device according to the invention.

Further advantages as well as advantageous characteristics of the invention appear from the following description and the other dependent claims.

### BRIEF DESCRIPTION OF THE DRAWINGS

With reference to the appended drawings, below follows a specific description of preferred embodiments of the invention cited as examples.

In the drawings:
- Fig. 1: is a longitudinal cross-section view of a device according to the prior art,
- Fig. 2: is a view similar to fig. 1 of a part of a device according to a first preferred embodiment of the invention,
- Fig. 3: is a view similar to fig. 2 of a device according to a second preferred embodiment of the invention,
- Fig. 4: is a view similar to fig. 2, of a device according to a third preferred embodiment of the invention,
- Fig. 5: is a view similar to fig. 2 of a device according to a fourth preferred embodiment of the invention,
- Fig. 6: is a view similar to fig. 2 of a device according to a fifth preferred embodiment of the invention,
- Fig. 7: is a view similar to fig. 2 of a device according to a sixth preferred embodiment of the invention,
- Fig. 8: is a view similar to fig. 2 but somewhat simplified of a device according to a seventh preferred embodiment of the invention, and
- Fig. 9: is a longitudinal cross section view substantially perpendicularly, i.e. from above, to the view according to fig. 8 of the device shown in fig. 8.

### DETAILED DESCRIPTION OF PREFERRED EMBODIMENTS OF THE INVENTION

Fig. 2 shows schematically a part of a device according to a preferred embodiment of the invention for epitaxially growing objects, in the following description by way of example referred to as SiC, by a method according to a preferred embodiment of the invention. It is obvious that the device in question also comprises many other means, such as pumps, but conventional equipment having nothing to do with the invention has been omitted for the sake of clearness and concentration to the inventional characteristics. The only difference between this device and the prior art device according to fig. 1 is that the substrate 3 is arranged in another way inside the susceptor in the device according to the invention than in fig. 1. More exactly, the device has means 7 for holding the substrate in the path 8 of said gas mixture through the susceptor at a distance away from internal walls 9 of the susceptor, in this case the bottom thereof. This holding means are here four graphite screws, one in each corner of a plate 10, preferably of SiC, on which the substrate 3 is arranged. Two elongated ribs of graphite extending in the flowing distribution may carry the plate instead of the screws. The SiC-plate 10 is therefor preventing etching of the rear side of the substrate.

The holding means are arranged to hold the substrate separated from said internal walls 9 by distance exceeding the thickness of a boundary layer 1 formed by the leading edge 4 of the susceptor. This means that the thickness 11 of the boundary layer over the substrate will now only depend on the distance between the leading edge 12 of the plate 10 and the substrate 3. As already said, this distance can be made as short as wanted, so that the diffusive length from the free flow of species through the susceptor may be reduced considerably and by that the growth rate increases correspondingly.

In the case of growing crystals of SiC it will be preferred to form said gas mixture of silane and propane as well as a carrier gas, such as Ar, H₂ or He. The heating means 6 will heat the susceptor to a temperature being high enough for cracking of the silane and propane when heated through the susceptor walls for forming Si and C depositing on the surface of the SiC crystal epitaxially grown. This means typically temperatures above 1 400°C, and preferably above 1 600°C.

The substrate 3 is arranged in the mid region 13 of the susceptor with respect to said path, and it is difficult to arrange it further upstream in the susceptor, since the precursors have to be heated enough before they reaches the substrate 3.

Another important advantage of separating the substrate 3 from the internal walls of the susceptor, so that it will have substantially no contact with said walls (except from the holding means 7) is that the back growth on the rear side of the SiC-plate 10 is reduced, since there is no longer such a large temperature difference between the front and rear side of the plate.

A device according to a second preferred embodiment of the invention is shown in fig. 3, and this has two holding means 7, one connected to a ceiling 14 of the susceptor for holding substrates 3 at said distance therefrom and another connected to the bottom 15 of the susceptor for holding other substrates at said distance therefrom. In this case two substrates are arranged in series along the gas mixture flow path, and this is made possible, since the temperature gradient in the flowing direction will be substantially decreased thanks to the fact that heat energy is substantially only transferred to the plates and the substrates through radiation. Accordingly, approximately the same temperature will prevail for the substrates arranged in series on a plate, so that objects may be grown thereon under substantially identical conditions. This embodiment means that layers of SiC may be grown at a much higher production rate than before, as a consequence of both a considerable reduction of said diffusive length and more substrates at the same time in the susceptor. More exactly, it has turned out that the growth rate depending on the shorter diffusive length may be increased considerably. At the same time, it may be possible to arrange for instance 2x2 substrates on the upper plate and just as many on the lower plate, so that then the production rate will increase further.

A device according to a third preferred embodiment is shown in fig. 4, and this differs from that shown in fig. 2 by the fact that the holding means is arranged to hold the substrate 3 inclined with respect to the path of the flow of said gas mixture through the susceptor, so that a perpendicular to the surface of the substrate has a component in the direction opposite to the direction of said flow. The angle made by the surface of the substrate 3 with the direction of the flow is small, preferably 1-15°. This results in optimal conditions for the growth.

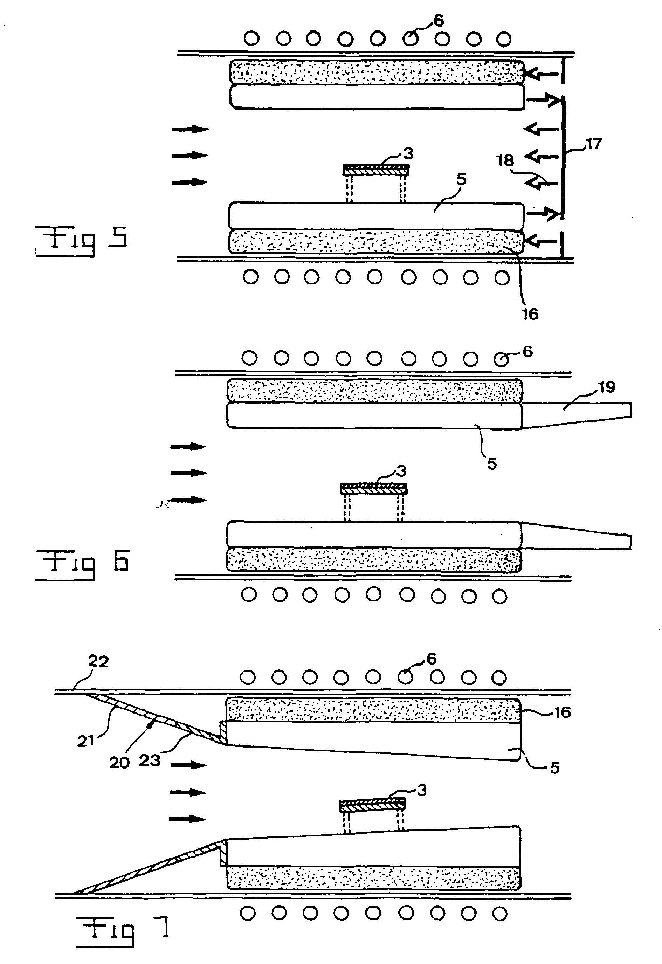

A device according to a fourth preferred embodiment of the invention is schematically shown in fig. 5. It is here illustrated how the walls of the susceptor 5 of dense graphite are surrounded by a heat-insulating layer 16 of foam. Some heat shields 17 are arranged downstream of the outlet of the susceptor for said flow of gases for reflecting thermal energy back towards the susceptor, which is indicated by the arrows 18. The hottest point in a conventional susceptor is located just in the mid region of the susceptor. After this position the temperature is decreasing. The temperature decrease is caused by thermal conduction. In the device according to fig. 5 the outlet/end wall exchanges energy with the surrounding by radiation. Because radiated energy is proportional to temperature to the fourth power, the contribution from the surrounding is negligible. The heat shield will find a temperature much closer to the outlet/end wall, and the radiative energy from the shield towards the susceptor will not be negligible, so that the energy will be "trapped" inside the shield. This means that it is possible to grow objects also in the end region of the susceptor under substantially the same temperature conditions as in the mid region, so that a possible growth region is extended and more objects may be grown simultaneously increasing the production rate of the device.

A device according to a fifth preferred embodiment of the invention is illustrated in fig. 6, and this differs from those already shown by the fact that the susceptor 5 is at a downstream end thereof prolonged by an outlet 19 substantially beyond the end of the heating means 6. This means that the heat loss from the susceptor is decreased, which is due to that the outlet will insulate the susceptor from the cooling flow and the thermal radiation losses, but also due to that the outlet 19 will be heated by the coil. Furthermore, the end effect and its eddy current flow is moved to the rear part of the outlet instead of the rear part of the susceptor. Finally, the outlet will work as a diffuser which will cause better flow conditions for the hot flow that leaves the susceptor. Accordingly, it will be possible to increase the number of objects grown in the susceptor without changing the susceptor geometry.

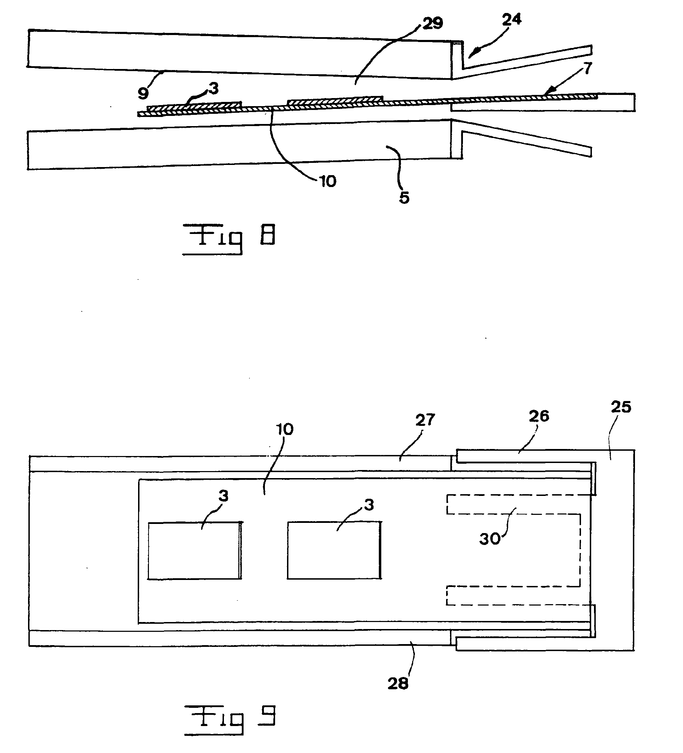

A device according to a sixth preferred embodiment of the invention is shown in fig. 7, and this differs from that shown in fig. 5 by the fact that the internal walls 5 are inclined, so that the same effect as in the embodiment according to fig. 4 is obtained, and that a funnel-like inlet 20 converging in the direction towards the susceptor and conducting said gas mixture into the susceptor is arranged. The inlet 20 has a first part 21 of quartz extending from the outer quartz tube 22 surrounding the susceptor and a second part 23 of graphite connecting to the susceptor. The funnel is circular with the same diameter as the quartz tube 22 at one end and rectangular with the same dimensions as the susceptor inlet hole at the other end. This funnel will improve the flow pattern of the gas mixture, insulate the susceptor from the cooling gas and will instead pre-heat the gas before it enters the susceptor more efficiently, insulate the susceptor from the radiative losses and shield off the gas flow from the rigid graphite insulation 16 and thereby decrease the amount of impurities coming from it. The inlet funnel is made of two different materials, because it is very hard (or impossible) to machine the whole in graphite.

A device according to a seventh preferred embodiment of the invention is shown in fig. 8 and 9, and this differs from those shown in the other figures mainly by the fact that the holding means 7 for the substrate 3 extends from a rear part 24 of the susceptor with respect to the flow direction of said gas mixture through the susceptor in the direction opposite to said flow while being separated from and without contact with the internal walls 9 of the susceptor along the extension thereof from said rear part. More exactly, the holding means comprises a member 25 having a fork-like design with two outer forks 26 secured to opposite lateral walls 27, 28 of the susceptor while being separated by them from a room 29 in which the growth is intended to take place. This is achieved by arranging longitudinal tracks in said walls into which the forks 26 are intended to be received. The member 25 has also a part 30 extending into said room 29 in the opposite direction to said flow in the form of two inner forks. These are arranged to carry a plate 10, preferably of SiC, extending into the room and on which the substrate 3, in this case two substrates, is arranged.

Thanks to the fact that the holding means can hold the plate 10 an by that the substrate 3 without touching any internal wall, i.e. floor, ceiling or lateral walls, of the susceptor room, problems of material transport from the walls to said holding means due to thermal gradients are efficiently avoided, so that the susceptor lifetime will be prolonged with respect to the embodiments illustrated in the other figures with holding means being attached to the internal walls. In such a case the temperature gradient between the susceptor walls and the holding means will cause material transport of the SiC-coating from the walls to the holding means (rods). Thereby the susceptor graphite will after a certain period of time be bared and the total pressure of hydrocarbons in the reactor will be increased. This is also a serious problem for the case when the loading plate is placed directly on the susceptor floor. This means that the susceptor lifetime is reduced, but more serious is as mentioned that the carbon plus impurities coming from the susceptor will be additionally uncontrolled growth parameters is not the susceptor taken out of operation in time. Another very important advantage of this way to hold the substrates is that the conditions for the growth of objects in different batches will be nearly exactly the same, so that the reproducibility of the objects will be excellent. This is due to arrangement of small marks not shown on the loading plate determining the position for each substrate, preferably by a snap-in action, and to the fact that forks 26 may be very exactly positioned in the tracks, so that the substrates in different batches will always have the same position. The angle of the substrates with respect to the gas flow will also always be the same.

The definition "object" in the claims is made for including the epitaxial growth of all types of crystals, such as layers of different thicknesses as well as thick boules.

All definitions concerning the material of course also include inevitable impurities as well as intentional doping. The holding means may have another appearance or be made of another material than described above.

The relative dimensions of the distance between opposite susceptor walls, the distance between the substrate and the susceptor walls etc. may be totally different than shown in the figures.

## Claims

1. A method for epitaxially growing objects by Chemical Vapour Deposition on a substrate (3) arranged in a susceptor (5), in which a gas mixture with components for said growth is fed into the susceptor to the substrate through an inlet with a leading edge (4), said susceptor being substantially completely open on the gas inlet side thereof, said substrate being located at a substantial distance downstream said leading edge (4) and extending substantially in the direction of the flow of said gas, and the substrate and the gas mixture fed thereto are heated through heating the susceptor, **characterized in that** the substrate is held in the path of said gas mixture through the susceptor at a distance (a) from internal walls (14, 15) thereof, so that there is a gas space between the back side of means holding the substrate and said internal walls.

2. A method according to claim 1, **characterized in that** the substrate (3) is held separated from said internal walls of the susceptor by at least a distance (a) corresponding to the thickness of a boundary layer (1) with a lower velocity of the gas mixture and created by a leading edge of the susceptor at the upstream thereof with respect to the flow of the gas mixture through the susceptor.

3. A method according to claim 1 or 2, **characterized in that** at least two substrates (3) are held in series along said gas mixture flow path at said distance from internal walls of the susceptor.

4. A method according to any of claims 1-3, in which the susceptor is arranged so as to make said path to extend substantially horizontally therethrough, **characterized in that** at least one substrate (3) is held in the susceptor at said distance from the ceiling (14) thereof and at least one substrate is held in said susceptor at said distance from the bottom (15) thereof.

5. A device for epitaxial growth of objects by Chemical Vapour Deposition on a substrate (3) comprising a susceptor adapted to receive said substrate, said susceptor being substantially completely open on a gas inlet side thereof having a leading edge (4), means for feeding a gas mixture for said growth into the susceptor through said inlet as ages flow passing said leading edge (4) while being directed towards said substrate, means (6) for heating walls of the susceptor (5) surrounding the substrate and by that the substrate and said gas mixture fed to the substrate for the growth and means (7, 10) adapted to hold the substrate in the path of said gas mixture through the susceptor at a substantial distance downstream said leading edge (4), so that the substrate extend substantially in the direction of the gas flow, **characterized in that** said means (7, 10) for holding the substrate is adapted to hold the substrate at a distance from internal walls (14, 15) of the susceptor so that there is a gas space between the back side of the means for holding substrate and said internal walls.

6. A device according to claim 5, **characterized in that** said means (7, 10) is arranged to hold the substrate separated from said internal walls (14, 15) of the susceptor by at least a distance (a) corresponding to a presumed thickness of a boundary layer (1) with a lower velocity of the gas mixture and created by said leading edge (4) of the susceptor.

7. A device according to claim 5 or 6, **characterized in that** said means (7) extends from a rear part (24) of the susceptor with respect to the flow direction of said gas mixture through the susceptor in the direction opposite to said flow while being separated from and without contact with said internal walls of the susceptor along the extension thereof from said rear part.

8. A device according to claim 7, **characterized in that** said holding means (7) is arranged to hold the substrate (3) at a distance from said rear part (24) as seen in the direction of said flow.

9. A device according to claim 7 or 8, **characterized in that** said holding means (7) is secured outside a room (29) of the susceptor defined by said internal walls (9) and in which said growth is intended to take place and extends into said room without any contact to said walls therein.

10. A device according to claim 9, **characterized in that** said holding means comprises a member (25) secured to the susceptor outside said room (29) and said member has a fork-like design with at least two forks (26) secured to opposite walls of the susceptor while being separated by them from said room (29).

11. A device according to claim 10, **characterized in that** said member (25) has a part (30) extending into said room in the opposite direction to said flow.

12. A device according to any of claims 9-11, **characterized in that** said holding means comprises a member (25) secured to the susceptor outside said room (29) and arranged to hold a plate (10) extending into said room and on which the substrate (3) is arranged.

13. A device according to claims 11 and 12, **characterized in that** said part (30) of said member (25) is arranged to carry said plate (10).

14. A device according to any of claims 5-13, **characterized in that** said holding means comprises a plate (10) of SiC, on which the substrate is arranged.

15. A device according to any of claims 5-14, **characterized in that** said holding means comprises a plate (10), on which at least two substrates (3) are arranged in series along said gas mixture flow path (8) at said distance (a) to internal walls (14, 15) of the susceptor.

16. A device according to any of claims 5,6 and 14,15, in which the susceptor is adapted to be arranged with said path (8) extending substantially horizontally therethrough, **characterized in that** it comprises two holding means (7, 10), one connected to a ceiling (14) of the susceptor for holding a substrate (3) at said distance therefrom and another connected to the bottom (15) of the susceptor for holding another substrate (3) at said distance therefrom.

17. A device according to any of claims 5-16, **characterized in that** said means (7, 10) is arranged to hold the substrate (3) in the mid region (13) of the susceptor with respect to said path between an inlet and an outlet thereof for said gas mixture.

18. A device according to any of claims 5-17, **characterized in that** said means (7, 10) is arranged to hold the substrate (3) inclined with respect to the path of the flow of said gas mixture through the susceptor, so that a perpendicular to the surface of the substrate has a component in the direction opposite to the direction of said flow.

19. A device according to any of claims 5-18, **characterized in that** the susceptor is at a downstream end thereof prolonged by an outlet (19) substantially beyond the end of the heating means (6).

20. A device according to any of claims 5-19, **characterized in that** at least one heat shield (17) is arranged downstream of an outlet of the susceptor for said flow of gases for reflecting thermal energy back towards the susceptor.

21. A device according to any of claims 5-20, **characterized in that** it has an inlet (20) connected to the upstream end of the susceptor and formed by converging walls guiding said gas mixture into the susceptor.

22. A device according to any of claims 5-21, **characterized in that** the walls of the susceptor (5) are made of dense graphite.

23. A device according to any of claims 5-22, **characterized in that** the heating means (6) is arranged to radiate a Rf-field.

24. A device according to any of claims 5-23, **characterized in that** it is adapted for the growth of an object of SiC, a group III-nitride or alloys of either SiC and one or more group III-nitrides or two or more group III-nitrides.

25. A device according to any of claims 5-24, **characterized in that** said heating means (6) is arranged to heat the susceptor and by that said substrate (3) and gas mixture to a temperature above 1 400°C.

## Patentansprüche

1. Verfahren für das epitaktische Wachstum von Objekten mittels chemischer Dampfphasenabscheidung auf einem Substrat (3), das in einem Suszeptor (5) angeordnet ist, wobei dem Suszeptor über einen Einlass mit einer Anströmkante (4) eine Gasmischung, welche Komponenten für das Wachstum enthält, zugeführt wird, der Suszeptor auf seiner Gaseinlassseite im Wesentlichen vollständig offen ist, das Substrat in einem erheblichen Abstand stromab der Anströmkante (4) angeordnet ist und sich im Wesentlichen in Strömungsrichtung des Gases erstreckt, und das Substrat und die diesem zugeführte Gasmischung durch Beheizen des Suszeptors erhitzt werden, **dadurch gekennzeichnet, dass** das Substrat in dem Strömungsweg der Gasmischung durch den Suszeptor hindurch in einem Abstand (a) von den Innenwänden (14, 15) des Suszeptors entfernt gehalten wird, so dass zwischen der Rückseite eines Mittels, welches das Substrat hält, und den Innenwänden ein Gasraum gegeben ist.

2. Verfahren nach Anspruch 1, **dadurch gekennzeichnet, dass** das Substrat (3) wenigstens in einem Abstand (a) von den Innenwänden des Suszeptors entfernt gehalten wird, wobei der Abstand (a) der Dicke einer Grenzschicht (1) entspricht, in welcher die Geschwindigkeit der Gasmischung niedriger ist und die durch eine Anströmkante des Suszeptors erzeugt wird, die sich, in Bezug auf die Strömung der Gasmischung durch den Suszeptor, am stromauf gelegenen Ende des Suszeptors befindet.

3. Verfahren nach Anspruch 1 oder 2, **dadurch gekennzeichnet, dass** wenigstens zwei Substrate (3) entlang des Strömungsweges der Gasmischung dem besagten Abstand von den Innenwänden des Suszeptors in Reihe angeordnet gehalten werden.

4. Verfahren nach einem der Ansprüche 1-3, bei dem der Suszeptor so angeordnet ist, dass der Strömungsweg im Wesentlichen horizontal durch diesen hindurch verläuft, **dadurch gekennzeichnet, dass** wenigstens ein Substrat (3) in dem Suszeptor in dem besagten Abstand von der Decke (14) des Suszeptors gehalten wird und wenigstens ein Substrat in dem Suszeptor in dem besagten Abstand von dem Boden (15) des Suszeptors gehalten wird.

5. Vorrichtung für das epitaktische Wachstum von Objekten mittels chemischer Dampfphasenabscheidung auf einem Substrat (3), umfassend einen Suszeptor, der für die Aufnahme des Substrats ausgelegt ist, wobei der Suszeptor auf seiner Gaseinlassseite, welche eine Anströmkante (4) aufweist, im Wesentlichen vollständig offen ist, ein Mittel für die Zuführung einer für das Wachstum bestimmten Gasmischung über den Einlass in den Suszeptor als Gasstrom, der an der Anströmkante (4) vorbei strömt, während er zum Substrat geführt wird, ein Mittel (6) zum Beheizen von das Substrat umgebenden Wänden des Suszeptors (5) und somit zum Erhitzen des Substrates und der dem Substrat für das Wachstum zugeführten Gasmischung, sowie ein Mittel (7, 10), das zum Halten des Substrates im Strömungsweg der Gasmischung durch den Suszeptor hindurch in einem erheblichen Abstand stromab der Anströmkante (4) ausgelegt ist, so dass sich das Substrat im Wesentlichen in der Strömungsrichtung des Gases erstreckt, **dadurch gekennzeichnet, dass** das Mittel (7, 10) zum Halten des Substrates so gestaltet ist, dass es das Substrat in einem Abstand von den Innenwänden (14, 15) des Suszeptors hält, so dass zwischen der Rückseite des Mittels zum Halten des Substrates und den Innenwänden ein Gasraum gegeben ist.

6. Vorrichtung nach Anspruch 5, **dadurch gekennzeichnet, dass** das Mittel (7, 10) so angeordnet ist, dass es das Substrat von den Innenwänden (14, 15) des Suszeptors getrennt hält, und zwar wenigstens in einem Abstand (a), der einer vermuteten Dicke einer Grenzschicht (1) entspricht, in welcher die Geschwindigkeit der Gasmischung niedriger ist und die durch die Anströmkante (4) des Suszeptors erzeugt wird.

7. Vorrichtung nach Anspruch 5 oder 6, **dadurch gekennzeichnet, dass** sich das Mittel (7) von einem, mit Bezug auf die Strömungsrichtung der Gasmischung durch den Suszeptor, hinteren Teil (24) des Suszeptors aus in der dieser Strömungsrichtung entgegen gesetzten Richtung erstreckt, wobei es entlang der von dem hinteren Teil ausgehenden Verlängerung desselben von den Innenwänden des Suszeptors getrennt und mit diesen Innenwänden nicht in Kontakt ist.

8. Vorrichtung nach Anspruch 7, **dadurch gekennzeichnet, dass** das Haltemittel (7) so angeordnet ist, dass es das Substrat (3) in einem Abstand von dem hinteren Teil (24), in der Richtung der Strömung gesehen, hält.

9. Vorrichtung nach Anspruch 7 oder 8, **dadurch gekennzeichnet, dass** das Haltemittel (7) außerhalb eines Raumes (29) des Suszeptors, welcher durch die Innenwände (9) definiert ist und in welchem das Wachstum stattfinden soll, befestigt ist und sich in diesen Raum hinein erstreckt, ohne dabei mit den Wänden in dem Raum in Kontakt zu sein.

10. Vorrichtung nach Anspruch 9, **dadurch gekennzeichnet, dass** das Haltemittel ein Element (25) umfasst, welches außerhalb des Raumes (29) an dem Suszeptor befestigt ist, und dass das Element eine gegabelte Konstruktion mit wenigstens zwei Gabeln (26) aufweist, die an gegenüberliegenden Seiten des Suszeptors befestigt sind, wobei es durch diese Gabeln von dem Raum (29) getrennt ist.

11. Vorrichtung nach Anspruch 10, **dadurch gekennzeichnet, dass** das Element (25) einen Teil (30) aufweist, der sich in der der Strömungsrichtung entgegen gesetzten Richtung in den Raum hinein erstreckt.

12. Vorrichtung nach einem der Ansprüche 9-11, **dadurch gekennzeichnet, dass** das Haltemittel ein Element (25) umfasst, welches außerhalb des Raumes (29) an dem Suszeptor befestigt und so angeordnet ist, dass es eine Platte (10) hält, welche sich in den Raum hinein erstreckt und auf der das Substrat (3) angeordnet ist.

13. Vorrichtung nach den Ansprüchen 11 und 12, **dadurch gekennzeichnet, dass** der Teil (30) des Elementes (25) derart angeordnet ist, dass er die Platte (10) trägt.

14. Vorrichtung nach einem der Ansprüche 5-13, **dadurch gekennzeichnet, dass** das Haltemittel eine Platte (10) aus SiC umfasst, auf welcher das Substrat angeordnet ist.

15. Vorrichtung nach einem der Ansprüche 5-14, **dadurch gekennzeichnet, dass** das Haltemittel eine Platte (10) umfasst, auf welcher wenigstens zwei Substrate (3) entlang des Strömungsweges (8) der Gasmischung, in dem Abstand (a) zu den Innenwänden (14, 15) des Suszeptors, in Reihe angeordnet sind.

16. Vorrichtung nach einem der Ansprüche 5, 6 und 14, 15, bei welcher der Suszeptor so angeordnet ist, dass der Strömungsweg (8) im Wesentlichen horizontal durch diesen hindurch verläuft, **dadurch gekennzeichnet, dass** die Vorrichtung zwei Haltemittel (7, 10) umfasst, von denen eines mit einer Decke (14) des Suszeptors verbunden ist, um ein Substrat (3) in dem besagten Abstand von der Decke entfernt zu halten, und ein anderes mit dem Boden (15) des Suszeptors verbunden ist, um ein anderes Substrat (3) in besagtem Abstand von dem Boden entfernt zu halten.

17. Vorrichtung nach einem der Ansprüche 5-16, **dadurch gekennzeichnet, dass** das Mittel (7, 10) so angeordnet ist, dass es das Substrat (3) in dem, mit Bezug auf den Strömungsweg, mittleren Bereich (13) des Suszeptors zwischen einem Einlass des Suszeptors für die Gasmischung und einem Auslass des Suszeptors für die Gasmischung hält.

18. Vorrichtung nach einem der Ansprüche 5-17, **dadurch gekennzeichnet, dass** das Mittel (7, 10) so angeordnet ist, dass es das Substrat (3) mit Bezug auf den Strömungsweg der Gasmischung durch den Suszeptor geneigt hält, so dass eine Senkrechte zu der Fläche des Substrates eine Komponente in der der Strömungsrichtung entgegen gesetzten Richtung aufweist.

19. Vorrichtung nach einem der Ansprüche 5-18, **dadurch gekennzeichnet, dass** sich der Suszeptor an dessen stromab gelegenen Ende durch einen Auslass (19) im Wesentlichen über das Ende des Heizmittels (6) hinaus erstreckt.

20. Vorrichtung nach einem der Ansprüche 5-19, **dadurch gekennzeichnet, dass** stromab eines Auslasses des Suszeptors für den Gasstrom ein Hitzeschild (17) angeordnet ist, welcher dazu dient, die thermische Energie zurück zum Suszeptor zu reflektieren.

21. Vorrichtung nach einem der Ansprüche 5-20, **dadurch gekennzeichnet, dass** sie einen Einlass (20) aufweist, der mit dem stromauf gelegenen Ende des Suszeptors verbunden und durch sich einander annähernde Wände gebildet ist, welche die Gasmischung in den Suszeptor hinein leiten.

22. Vorrichtung nach einem der Ansprüche 5-21, **dadurch gekennzeichnet, dass** die Wände des Suszeptors (5) aus dichtem Graphit bestehen.

23. Vorrichtung nach einem der Ansprüche 5-22, **dadurch gekennzeichnet, dass** das Heizmittel (6) zum Ausstrahlen eines HF-Feldes angeordnet ist.

24. Vorrichtung nach einem der Ansprüche 5-23, **dadurch gekennzeichnet, dass** sie für das Wachstum eines Objektes aus SiC, aus einem Gruppe-III-Nitrid oder aus Legierungen, die entweder aus SiC und einem oder mehreren Gruppe-III-Nitriden oder aus zwei oder mehr Gruppe-III-Nitriden bestehen, ausgelegt ist.

25. Vorrichtung nach einem der Ansprüche 5-24, **dadurch gekennzeichnet, dass** das Heizmittel (6) zum Erhitzen des Suszeptors und damit des Substrates (3) und der Gasmischung auf eine Temperatur von mehr als 1400 °C vorgesehen ist.

## Revendications

1. Procédé de croissance épitaxiale d'objets par dépôt chimique en phase vapeur sur un substrat (3) placé dans un suscepteur (5), dans lequel on envoie un mélange gazeux ayant des constituants pour la croissance dans le suscepteur au substrat par une entrée ayant un bord (4) d'attaque, le suscepteur étant sensiblement complètement ouvert sur son côté d'entrée du gaz, le substrat étant placé à une distance substantielle en aval du bord (4) d'attaque et s'étendant sensiblement dans la direction du courant de gaz et on chauffe le substrat et le mélange gazeux qui y est envoyé en chauffant le suscepteur, **caractérisé en ce que** l'on maintient le substrat dans le trajet du mélange gazeux dans le suscepteur à une distance (a) de ses parois (14, 15) intérieures de sorte qu'il y ait un espace pour du gaz entre le côté arrière de moyens de maintien du substrat et les parois arrières.

2. Procédé suivant la revendication 1, **caractérisé en ce que** l'on maintient le substrat séparé des parois intérieures du suscepteur d'au moins une distance (a) correspondant à l'épaisseur d'une couche (1) limite ayant une vitesse du mélange gazeux et créée par un bord d'attaque du suscepteur en amont de celui-ci plus petite que celle du courant de mélange gazeux dans le suscepteur.

3. Procédé suivant la revendication 1 ou 2, **caractérisé en ce qu'**on maintient au moins deux substrats (3) en série le long du trajet d'écoulement du mélange gazeux à ladite distance des parois intérieures du suscepteur.

4. Procédé suivant l'une quelconque des revendications 1 à 3, dans lequel on agence le suscepteur de manière à faire que le trajet s'y étende sensiblement horizontalement, **caractérisé en ce qu'**on maintient au moins un substrat (3) dans le suscepteur à ladite distance de son plafond (14) et on maintient au moins un substrat dans le suscepteur à ladite distance de son fond (15).

5. Dispositif de croissance épitaxiale d'objets par dépôt chimique en phase vapeur sur un substrat (3) comprenant un suscepteur conçu pour recevoir le substrat, le suscepteur étant sensiblement complètement ouvert sur son côté d'entrée du gaz ayant un bord (4) d'attaque, des moyens d'envoi d'un mélange gazeux pour la croissance dans le suscepteur par l'entrée alors qu'un gaz passe dans le bord (4) d'attaque tout en étant dirigé vers le substrat, des moyens pour chauffer les parois du suscepteur (5) entourant le substrat et par cela le substrat et le mélange gazeux envoyé au substrat pour la croissance, **caractérisé en ce que** les moyens (7, 10) de maintien du substrat sont conçus pour maintenir le substrat à une distance des parois (14, 15) intérieures du suscepteur de sorte qu'il y ait un espace pour du gaz entre le côté arrière des moyens de maintien du substrat et les parois intérieures.

6. Dispositif suivant la revendication 5, **caractérisé en ce que** les moyens (7, 10) sont conçus pour maintenir le substrat, séparé des parois (14, 15) intérieures du suscepteur, d'au moins une distance (a) correspondant à une épaisseur présumée de la couche (1) limite ayant une vitesse plus petite du mélange gazeux et créée par le bord (4) d'attaque du suscepteur.

7. Dispositif suivant la revendication 5 ou 6, **caractérisé en ce que** les moyens (7) s'étendent d'une partie (24) arrière du suscepteur, par rapport au sens d'écoulement du mélange gazeux dans le suscepteur, dans le sens opposé à cet écoulement, tout en étant séparé des parois intérieures du suscepteur et sans contact avec elles le long de leur étendue à partir de la partie arrière.

8. Dispositif suivant la revendication 7, **caractérisé en ce que** les moyens (7) de retenue sont conçus pour retenir le substrat (3) à une distance de la partie (24) arrière telle que vu dans le sens de l'écoulement.

9. Dispositif suivant la revendication 7 ou 8, **caractérisé en ce que** les moyens (7) de retenue sont fixés à l'extérieur d'une chambre (29) du suscepteur définie par les parois (9) intérieures et dans laquelle la croissance doit avoir lieu et s'étendent dans la chambre sans contact avec les parois.

10. Dispositif suivant la revendication 9, **caractérisé en ce que** les moyens de retenue comprennent un élément (25) fixé au suscepteur à l'extérieur de la chambre (9) et l'élément a un agencement en fourche ayant au moins deux fourches (26) fixées à des parois opposées du suscepteur tout en étant séparées par elles de la chambre (29).

11. Dispositif suivant la revendication 10, **caractérisé en ce que** l'élément (25) a une partie (30) s'étendant dans la chambre dans le sens opposé à l'écoulement.

12. Dispositif suivant l'une quelconque des revendications 9 à 11, **caractérisé en ce que** les moyens de retenue comprennent un élément (25) fixé au suscepteur à l'extérieur de la chambre (29) et conçu pour maintenir une plaque (10) s'étendant dans la chambre et sur lequel le substrat (3) est placé.

13. Dispositif suivant les revendications 11 et 12, **caractérisé en ce que** la partie (30) de l'élément (25) est conçu pour porter la plaque (10).

14. Dispositif suivant l'une quelconque des revendications 5 à 13, **caractérisé en ce que** les moyens de retenue comprennent une plaque (10) en SiC, sur lequel le substrat est posé.

15. Dispositif suivant l'une quelconque des revendications 5 à 14, **caractérisé en ce que** les moyens de retenue comprennent une plaque (10) sur laquelle au moins deux substrats (3) sont disposés en série le long du trajet (8) d'écoulement du mélange gazeux à la distance (a) des parois (14, 15) intérieures du suscepteur.

16. Dispositif suivant l'une quelconque des revendications 5, 6 et 14, 15, dans lequel le suscepteur est conçu pour être disposé alors que le trajet (8) s'y étend sensiblement horizontalement, **caractérisé en ce qu'**il comprend deux moyens (7, 10) de maintien, l'un relié au plafond (14) du suscepteur pour maintenir un substrat (3) à ladite distance de celui-ci et un autre relié au fond (15) du suscepteur pour maintenir un autre substrat (3) à ladite distance de celui-ci.

17. Dispositif suivant l'une quelconque des revendications 5 à 16, **caractérisé en ce que** les moyens (7, 10) sont conçus pour maintenir le substrat (3) dans la région (13) médiane du suscepteur par rapport au trajet entre son entrée et sa sortie pour le mélange gazeux.

18. Dispositif suivant l'une quelconque des revendications 5 à 17, **caractérisé en ce que** les moyens (7, 10) sont conçus pour maintenir le substrat (3) incliné par rapport au trajet de l'écoulement du mélange gazeux dans le suscepteur de sorte qu'une perpendiculaire à la surface du substrat a une composante dans le sens opposé au sens de l'écoulement.

19. Dispositif suivant l'une quelconque des revendications 5 à 18, **caractérisé en ce que** le suscepteur est, à son extrémité en aval, prolongé par une sortie (19) sensiblement au-delà de l'extrémité des moyens (6) de chauffage.

20. Dispositif suivant l'une quelconque des revendications 5 à 19, **caractérisé en ce qu'**au moins un bouclier (17) thermique est disposé en aval d'une sortie du suscepteur pour l'écoulement de gaz afin de réfléchir de l'énergie thermique vers le suscepteur.

21. Dispositif suivant l'une quelconque des revendications 5 à 20, **caractérisé en ce qu'**il a une entrée (20) communiquant avec l'extrémité amont du suscepteur et formée de parois convergentes guidant le mélange gazeux dans le suscepteur.

22. Dispositif suivant l'une quelconque des revendications 5 à 21, **caractérisé en ce** les parois du suscepteur (5) sont en graphite dense.

23. Dispositif suivant l'une quelconque des revendications 5 à 22, **caractérisé en ce que** les moyens (6) de chauffage sont conçus pour rayonner un champ de haute fréquence.

24. Dispositif suivant l'une quelconque des revendications 5 à 23, **caractérisé en ce qu'**il est conçu pour la croissance d'un objet en SiC, d'un nitrure du groupe III ou d'alliages de SiC et de l'un ou plusieurs nitrures du groupe III ou de deux ou plusieurs nitrures du groupe III.

25. Dispositif suivant l'une quelconque des revendications 5 à 24, **caractérisé en ce que** les moyens (6) de chauffage sont conçus pour porter le suscepteur et par cela le substrat (3) et le mélange gazeux à une température supérieure à 1400°C.
